# EUROPEAN PATENT SPECIFICATION

(11) **EP 4 474 341 B1**
(45) Date of publication and mention of the grant of the patent: **15.07.2026**
(21) Application number: 23177967.9
(22) Date of filing: 07.06.2023
(51) Int. Cl.: B81B 7/00

(54) **MEMS DEVICE WITH A CAP LAYER HAVING GAPS AND METHOD OF MANUFACTURING A MEMS DEVICE**
MEMS-VORRICHTUNG MIT EINER DECKSCHICHT MIT LÜCKEN UND VERFAHREN ZUR HERSTELLUNG EINER MEMS-VORRICHTUNG
DISPOSITIF MEMS AVEC UNE COUCHE DE RECOUVREMENT AYANT DES ESPACES ET PROCÉDÉ DE FABRICATION D'UN DISPOSITIF MEMS

(43) Date of publication of application: 11.12.2024
(73) Proprietor: Murata Manufacturing Co., Ltd., Nagaokakyo-shi, Kyoto 617-8555 (JP)
(72) Inventor: HANNULA, Konsta, 04130 Sipoo (FI); OKSANEN, Jussi, 03100 Nummela (FI); AAV, Jussi, 01180 Kalkkiranta (FI)
(74) Representative: Boco IP Oy Ab

(56) References cited:
- EP-A1- 3 705 451
- CN-A- 115 403 005

## Description

### Field

The present invention relates to an apparatus and methods of manufacturing such apparatus related to microelectromechanical system (MEMS) devices. More particularly, the invention relates to a design of a cap layer of a MEMS device and methods of manufacturing of the cap layer and a MEMS device with the cap layer.

### Background

In this context a seismic element refers to an internal, physically moving element of a MEMS device. Seismic elements of a MEMS device are typically comprised in one or more structural layers referred to as device layer(s). Any number of seismic elements may be provided in the MEMS device. A seismic element may be configured for translational and/or rotational movement in response to any physical phenomenon, such as acceleration or pressure. The seismic element may be driven into a motion by driving means, such as capacitive or piezoelectric transducers. The seismic element may be configured to move in response to the Coriolis force affecting the seismic element first driven into a motion by transducers.

The MEMS structures may include a plurality of layers. Layers are attached to each other by bonding. Practical MEMS processes use modified semiconductor device fabrication and packaging technologies, so the bonding is often one of successive wafer-level processes, wherein a large number of MEMS structures are manufactured jointly, and then diced for separate use. In a typical MEMS device, bonded surfaces of layers form a continuously closed peripheral region in a plane around the internal part so that one or more hermetically sealed internal spaces are formed into the MEMS structure, the internal spaces comprising seismic elements.

Gaps are provided in the MEMS device to provide space for seismic elements to move as intended. A common solution to provide gaps is to recess seismic elements from one or two horizontal outer surfaces of the device layer to create sufficient space for movement of seismic elements. Mere creation of free space is not always sufficient, but for example capacitive MEMS devices should also be provided with accurate dimensions to control distances between moving electrodes attached or associated with seismic elements and stationary electrodes.

In some MEMS devices, one or more device layers are sandwiched between so called bottom layer and cap layer. In typical MEMS accelerometers and gyroscopes, seismic elements are hermetically encapsulated between the bottom layer and cap layer, and electrical contacts are routed through the cap layer.

Patent application CN 115403005 A discloses a pressure sensing module and a method to make a resistive pressure sensor.

Patent application EP 3705451 A1 discloses a MEMS structure with a gap fill section made or glass.

### Summary

An object is to provide a MEMS device and a MEMS device manufacturing method so as to improve accuracy of dimensions with respect to seismic elements and/or other functional elements on a device layer. The objects of the present invention are achieved with a MEMS device according to claim 1. Objects of the present invention are further achieved with a manufacturing method according to claim 9.

The preferred embodiments of the invention are disclosed in the dependent claims.

The present invention is based on the idea of providing one or more gaps in the cap layer, instead of providing gaps in a device layer to increase distance between these two layers, to provide sufficient space for desired motions of one or more seismic elements of the device layer when these layers are superposed.

According to embodiments of the invention, a MEMS device is provided. The MEMS device comprises a cap layer and a device layer. The cap layer comprises a cap wafer made of electrically insulating material, such as glass. The device layer comprising at least one seismic element.

The cap layer comprises at least one silicon-filled portion at a first face of the cap layer facing the device layer, and at least one of said at least one silicon-filled portion comprises a gap. The gap is a recessed area in the respective silicon-filled portion that locally increases distance from the cap layer to the at least one seismic element comprised in the device layer.

According to some embodiments, the plurality of silicon-filled portions is filled with monocrystalline silicon or with polycrystalline silicon.

According to some embodiments, the cap layer further comprises at least one silicon bump extending from the gap towards the device layer. The silicon bump is electrically insulated from other portions of the gap by at least one exposed portion of the cap wafer.

According to some embodiments, the MEMS device further comprises at least one metal film pattern disposed on a silicon surface of the gap.

According to some embodiments, the MEMS device further comprises at least one bump extending from the at least one metal film pattern towards the device layer.

According to some embodiments, at least one of the silicon-filled portions forms a silicon pillar extending between the first face of the cap layer and a second face of the cap layer facing away from the device layer.

According to some embodiments, the cap layer comprises at least one metallic press contact configured to electrically couple the cap layer to the superposed device layer.

According to some embodiments, at least one exposed portion of glass at the first face of the cap layer comprises at least one recess configured to facilitate metal bonding of the first face of the cap layer with the device layer.

According to embodiments of the invention, a method of manufacturing a MEMS device is provided. The method comprises a) providing a three-dimensionally patterned silicon mold, b) depositing glass or applying heat-softened glass on the three-dimensionally patterned silicon mold to create a cap wafer with a three-dimensionally patterned first face, and optionally grinding the cap wafer to remove excess edge glass and/or to planarize a second face of the cap wafer and c) removing at least part of the silicon mold by grinding and/or chemical-mechanical polishing. The method optionally comprises d) removing remaining portions of the silicon mold by etching. The method then comprises, e) if the remaining portions of the silicon mold are removed by etching in step d), depositing a layer of polysilicon on the first face of the cap wafer, and thinning the deposited layer of polysilicon by grinding and/or chemical-mechanical polishing.

As a result of step c) or step e), the first face of the cap layer comprises a flat surface comprising one or more silicon-filled portions and one or more areas of exposed glass.

The method further comprises f) at least partially recessing at least one of the one or more silicon-filled portions below the flat surface at the first face of the cap layer by etching to generate at least one gap, and h) bonding the cap wafer at its first face to a device layer such that the at least one gap is superposed with one or more seismic elements comprised in the device layer.

According to some embodiments, the method further comprises, between steps f) and h), placing at least one metal film pattern on the first face of the cap layer at a bottom of at least one of the at least one gap.

According to some embodiments, the method further comprises generating at least one bump on the metal film pattern.

According to some embodiments, at least one of the at least one silicon-filled portion forms a silicon pillar extending from the first face of the cap layer towards the second face of the cap layer. The method further comprises either, before step h) performing step g) thinning the cap wafer at the second face of the cap layer to expose the at least one silicon pillar on the second face of the cap layer, or after step h) performing step i) thinning the cap layer at the second face to expose the at least one silicon pillar at the second face of the cap layer. The at least one silicon pillar exposed at both faces of the cap wafer, provides an electrical contact between the first face of the cap layer and the second face of the cap layer.

According to some embodiments, the method comprises providing at least one of the at least one silicon pillar with a metallic press contact at the first face of the cap layer.

According to some embodiments, i) the three-dimensionally patterned silicon mold determines at least one recess that is not filled with poly-Si in the step e), or ii) the three-dimensionally patterned silicon mold determines at least one recess from which all deposited poly-Si is removed in the step f), or iii) the method further comprises a step of etching at least one recess in at least one area of exposed glass at the first face of the cap wafer. The at least one recess at the first face of the cap wafer is used for metal bonding, and the bonding step h) comprises: providing the at least one recess with a first metal pattern at the bottom thereof, providing at least one second metal pattern on a face of the device layer configured to face the first face of the cap layer, wherein the second metal pattern is superposed with a respective first metal pattern when the cap layer and the device layer are superposed, and metal bonding the first face of the cap layer with the face of the device layer by heating the first metal pattern and the second metal pattern to form a eutectic metal phase.

According to some embodiments of the invention, the first metal pattern comprises any one of aluminium or germanium, and the second metal pattern comprises the other one of aluminium and germanium.

The present invention enables new types of cap layer designs. For example, the cap layer design may have narrower silicon structures coupled to wider silicon areas. The amount of exposed glass or any other cap wafer material can be reduced on bonding surface between the cap layer and a device layer, even without additional metal shields in the cap layer. Silicon electrodes can be provided in the cap layer instead of traditional metal film electrodes on the bottom face of the cap layer. Out-of-plane bumps, such as one or more electrically isolated silicon bumps, may be provided on the cap layer. Getter size can be reduced by increasing its effective area by adding surface topography below the getter. As is known in the art, a getter is a deposit of reactive material that is placed inside a vacuum system to complete and maintain the vacuum. When gas molecules strike the getter material, they combine with it chemically or by absorption. Thus, the getter removes small amounts of gas from the evacuated space. Metal bonding or anodic bonding may be used for bonding the cap layer to the device layer of the MEMS device. Alkali-free glasses can be used for the cap layer in metal bonding.

### Brief description of the drawings

In the following the invention will be described in greater detail, in connection with preferred embodiments, with reference to the attached drawings, in which
Figure 1 is a cross section of a cap layer.
Figures 2A to 2F illustrate steps of a manufacturing process of a cap layer and bonding a thinned cap layer to a device layer.
Figure 3 illustrates an alternative implementation of electrical wiring
Figures 4A and 4B illustrate metal bonding of the cap layer and thinning of the bonded cap layer.
Figures 5A and 5B illustrate metal bonding of two flat surfaces
Figures 6A and 6B illustrate metal bonding with a recess
Figures 7A to 7D illustrate steps of an alternative manufacturing process steps of a cap layer

Drawings are not in scale. Drawings do not illustrate an actual MEMS device design but represent a collection of exemplary structural elements which can be used as elements of a functional MEMS device and manufacturing steps for generating such structural elements.

### Detailed description

In the following description, terms "up" and "down" as well as relative terms such as above, below, upward and downward refer to directions with respect to the z-axis in the respective drawings. Manufacturing process steps are typically performed from above the wafer, and thus the wafer is flipped upside down every now and then. Positions of the mold and various layers of the MEMS device become obvious to a skilled person from the drawings. It should be understood that these directions do not limit the position of the cap layer or the MEMS device comprising such cap layer when manufactured or when in use. The term lateral dimension refers to a dimension in direction of x-y plane in the drawings, while terms like thickness and depth refer to dimensions in the z-axis direction and terms like thinning and recessing refer to changing dimensions in the z-axis direction.

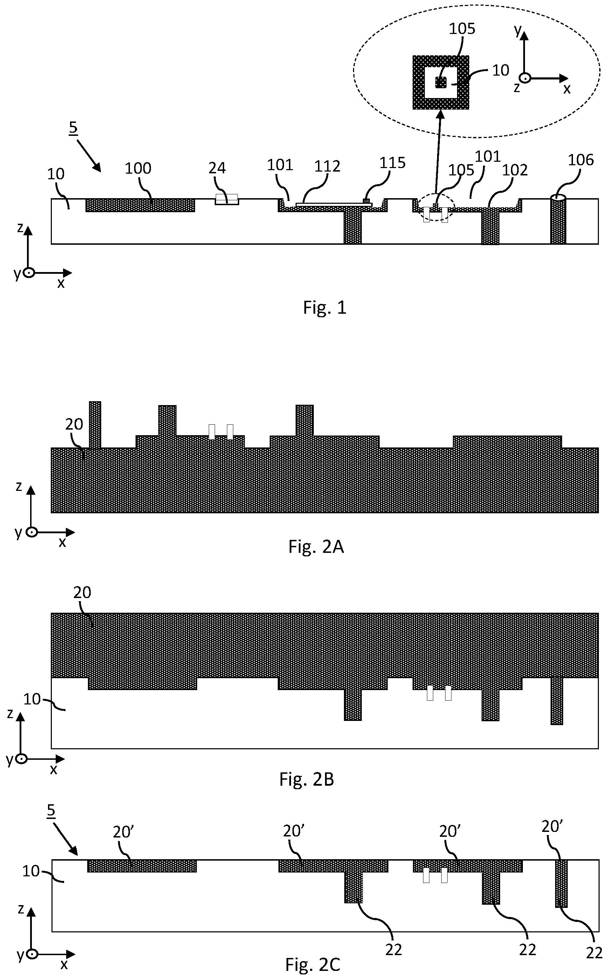

Figure 1 is a cross section of a cap layer 5 according to some embodiments. In this context, term cap layer 5 refers to the entire cap structure, and term cap wafer 10 refers to the insulating material, such as glass, which can alternatively be referred to as substrate. Since the cap layer is to be bonded to the silicon wafer based device layer(s), coefficient of thermal expansion of the insulating material of the cap wafer 10 should be similar to a silicon wafer to provide a robust MEMS device not susceptible to tension caused by change of temperatures. Examples of applicable glass materials for the cap wafer 10 are for example borosilicate glasses, such as Corning Pyrex^{®} 7740 and Schott Borofloat^{®}33 Also alkali-free glasses such as Schott AF32^{®} can be used, which has a low coefficient of thermal expansion similar to a silicon wafer.

Various functional elements may be provided on the cap layer 5. Functional elements may have mechanical and/or electrical characteristics. Functional elements comprise silicon-filled areas 100, recessed silicon filled areas referred to as gaps 101, which may be provided with metal film patterns 112 such as metal electrodes and optionally bumps 115, both of which are also considered functional elements. Term bump refers to a mechanical movement limiter. Bumps may be electrically connected or electrically isolated. Further functional elements may comprise a silicon electrode 102, as well as one or more electrically insulated silicon bumps 105 extending towards device layer from the cap layer's surface. A top view of a silicon bump 105 encircled in the cross-section is shown, in which the insulating cap layer area surrounds the silicon bump 105. Furthermore, the cap layer may be provided with a press contact 106 comprising an electrically conducting silicone pillar or "via" through the cap layer and a silicon bump. The press contact 106 may be used for making electrical contact between two wafers when stacked. Such electrical contact may be needed, for example for signal routing between different layers in MEMS sensors.

Figures 2A to 2F illustrate steps of a manufacturing process of a cap layer using a mono-Si mold and bonding the cap layer on a device layer according to some embodiments.

Figure 2A illustrates a mold 20, preferably a silicon mold. Preferably, the mold 20 is made out of a single crystal silicon wafer. The mold 20 is patterned using known silicon wafer patterning methods, such as thermal oxidation and deep reactive ion etching (DRIE).

Single-crystal silicon, mono-Si, known also as monocrystalline silicon is the well-known base semiconductor material for silicon-based discrete components and integrated circuits. It consists of silicon in which the crystal lattice of the entire solid is continuous. Mono-Si is the material of first choice for robust MEMS devices, because of its excellent mechanical strength and elasticity, and the large variety of available standard processes. It is well known in the art, that in MEMS devices, mono-Si layer is used as a conductor, for which purpose it is doped to make it electrically conducting. For example, Boron-doped P-type silicon wafers are common, but also Phosphorus-doped N-type wafers are used in some special applications.

Figure 2B illustrates a result after molding of insulating cap wafer 10. When glass is used as cap wafer 10, heat-softened glass may be applied/inserted on the mold 20 or glass may be deposited on the mold 20 in any other applicable way. A typical glass molding process further comprises grinding to remove any excess edge glass at the lateral sides of the cap wafer 10 and to planarize the xy-plane direction glass surface.

Figure 2C illustrates a result of grinding and/or chemical-mechanical polishing to remove excess mold 20 from the patterned surface. Portions 20' of the mold remain in recesses of the insulating material of the cap wafer 10, including silicon pillars 22, which may be comprised in some MEMS device designs.

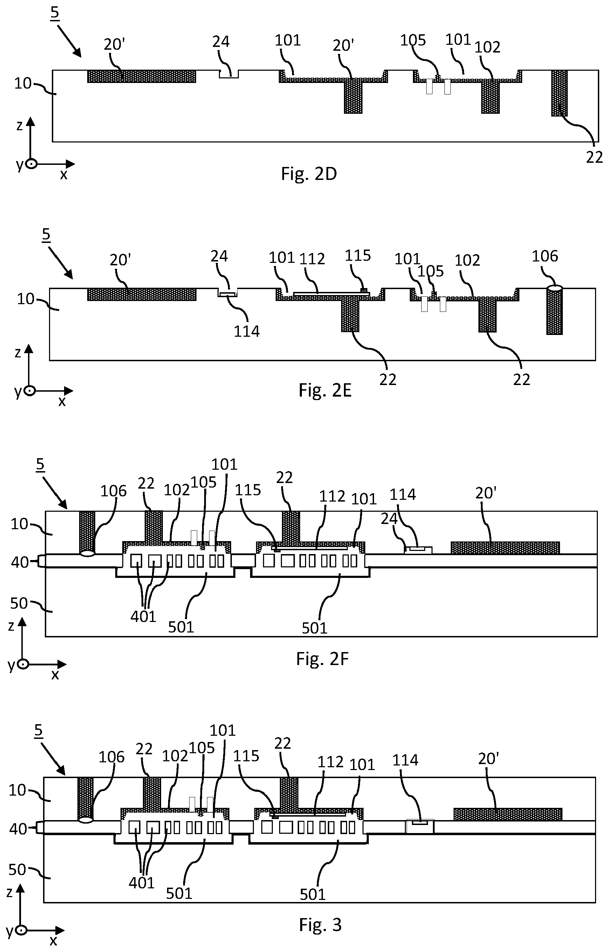

Figure 2D illustrates results of next step, in which one or more gaps 101 are formed in selected ones of the remaining mono-Si portions 20' of the mold. Gaps 101 refer to recessed areas in the mono-Si portions 20', where the silicon is recessed from the initial, flat upper face of the cap layer 5 after grinding the mold. Gaps 101 are preferably created by dry etching, such as DRIE or plasma enhanced reactive ion etching (PERIE). For forming an electrically isolated silicon bump 105, more than one mask and more than one dry etching step may be used. The cap layer may also comprise one or more recesses 24. The recess 24 can be generated by etching the cap wafer 10, or they may be generated with help of the mold. If mold was used for generating the recess 24 of figures 2A to 2D, the remaining portion of the silicon mold in a relatively shallow recess 24 can be removed simultaneously with forming the gaps 101.

Figure 2E illustrates results of further, optional metal processing steps of cap layer manufacturing. Metal processing steps can be used for generating metal film patterns 112 such as metal electrodes, when needed on the bottom of one or more gaps 101 the cap in the MEMS device design. One or more metal film patterns 112 are patterned in the selected gaps 101. Optionally, bumps 115 are formed on one or more metal film patterns 112. As known in the art, bumps 115 are used in MEMS devices to prevent sticking of a seismic element to an electrode if these would accidentally touch each other for example due to an excess shock. Bumps may be made of various materials, a non-limiting examples of which are ceramic oxides with diamond-like-carbon film (DLC). In some embodiments, one or more press contacts 106 can be provided in a metal processing step by forming a metal pattern.

Also, electrical wiring 114 for routing electrical signals may be added on the top face of the cap wafer 10. In this example, electrical wiring 114 is placed in a recess 24 on the cap wafer 10.

Figure 2F illustrates bonding the cap layer 5 to a device layer 40 upon superposing the two layers in anodic bonding.

By thinning the cap layer 5, silicon pillars 22 are exposed on the upper face of the cap layer, away from the device layer 40. Thinning may be implemented using grinding and/or chemical mechanical polishing. In this example press contact 106 and/or any of the exposed silicon pillars 22 can be used for providing an electrical connection from the upper face of the cap layer 5 all the way to the device layer 40. Silicon pillars 22 may also or alternatively be used for electrical connections of the MEMS device's electrodes and/or transducers when in operation.

A device layer 40 comprising a plurality of seismic elements 401 is sandwiched between the cap layer and a bottom layer 50. The cap layer 5 comprises gaps 101 that increase distance from the upper face of the device layer 40 to the cap layer 10 such that there is space above seismic elements 401 to move upwards. The bottom layer 50 also comprises gaps 501 to increase distance from the bottom face of the device layer 40 to the bottom layer 50 such that there is space below the seismic elements 401 to move downwards. This way, the device layer 40 can be implemented essentially flat: gaps 501 provided in the bottom layer 50 and gaps 101 provided in the cap layer leave sufficient free space for the seismic elements 401 to move up and down as needed. By implementing gaps 101, 501 in the cap layer 5 and in the bottom layer 50, the device layer does not have to be recessed, but entire thickness of the device layer 40 can be utilized for the seismic elements 401, which enables maximizing mass of seismic elements 401. The flat device layer can be patterned using planar lithography, which improves accuracy of patterning of the device layer. Planar lithography facilitates better control of line widths over the entire lateral dimension of the device wafer.

Figure 2F also shows electrical wiring 114 in a recess 24 on the cap layer 5. By placing the electrical wiring 114 in a recess of the cap layer 5, electrical contact can be avoided between the electrical wiring 114 and device layer 40.

Figure 3 shows an alternative method to implement electrical wiring 114 for routing signals and/or for electrical grounding when the cap layer 5 is superposed with the device layer 40. This electrical wiring 114 may be manufactured during the same metal processing step or steps that are used to generate other metal film patterns 112 such as metal electrodes. In this example, the cap layer is not recessed under the electrical wiring 114, but the device layer 40 is patterned to avoid unwanted contacts with the electrical wiring 114.

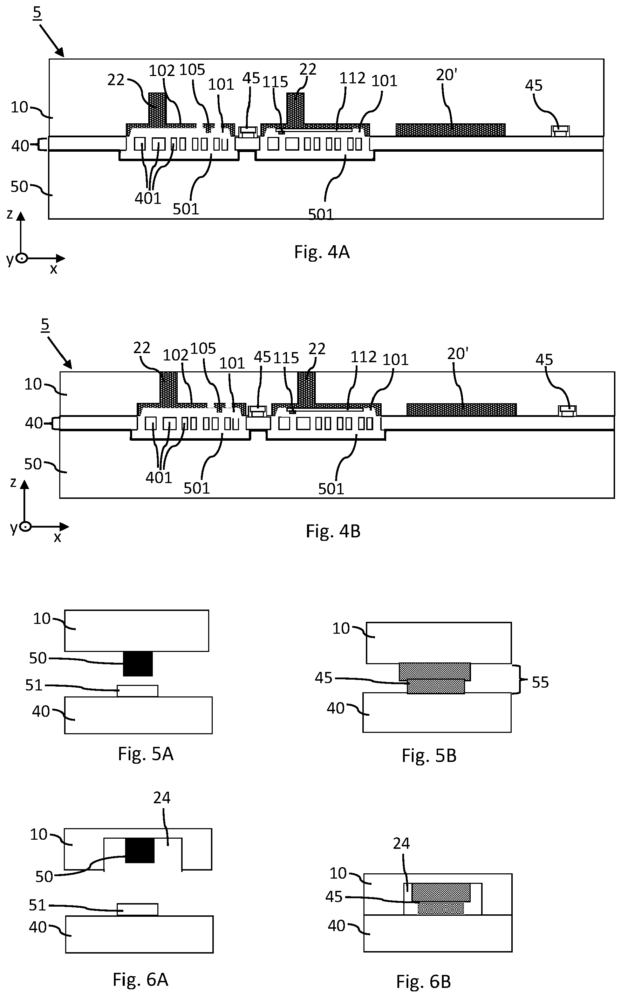

Figures 4A and 4B illustrate metal bonding of the cap layer according to some embodiments.

Structural parts of the base layer 50, device layer 40 and cap layer 5 are similar as already explained above. In this embodiment, the cap layer 5 is bonded to the device layer 40 by metal bonding 45. An example of applicable metal bonding is so called AlGe wafer bonding. In AlGe wafer bonding, germanium is typically provided on face of one wafer and aluminum is provided on face of the other wafer. To facilitate metal bonding, further thin coating layers may be provided in addition to the metals themselves. During metal bonding, the provided germanium and aluminum form a eutectic AlGe-phase. As known in the art, a eutectic phase is a melting composition of minimum two components, each of which melts and freezes congruently. During crystallization phase, a mixture of the components is formed, hence acting as a single component.

Cap wafer 10 may be bonded first, as shown in the figure 3a, and thinned only after bonding has been completed, as shown in the figure 3b, to expose the silicon pillars 22 for providing electrical connections to electrodes and/or electromechanical transducers. Alternatively, thinning of the cap wafer 10 may be performed before bonding. No press contact is needed in this embodiment. Thinning of the cap layer 5 may be performed by chemical-mechanical grinding and polishing.

Figures 5A, 5B, 6A and 6B illustrate benefits achieved by having a recess 24 for metal bonding. Although this example is illustrated with a specific combination of metals, a skilled person understands that the same arrangement with a recess can be applied with any selected bonding metal combinations.

Figures 5A and 5B illustrate metal bonding of two flat surfaces. Figure 5A shows aluminum 50 patterned on the flat bottom face of the cap wafer 10, and germanium 51 patterned on the flat top face of the device layer 40. Figure 5B illustrates the result of metal bonding, in which aluminum and germanium have formed a eutectic AlGe-phase. The problem in this arrangement is that vertical distance 55 between the cap wafer and the device layer is difficult to control in the manufacturing process, which inevitably causes vertical distance between functional elements in the device layer and functional elements to be likewise difficult to control.

Figures 6A and 6B illustrate metal bonding using a recess 24 formed on the cap wafer 50. As shown in figure 6A, aluminum 50 is patterned at the bottom of the recess 24, while germanium is patterned on the flat top face of the device layer 40. The result of the metal bonding step is that the metal bonding 45 comprising the eutectic AlGe-phase is within the recess 24, and bottom face of the cap wafer 10 and top face of the device layer 40 become in contact with each other. In other words, the metal bonding 45 is entirely within the recess 24 such that distance between non-recessed portions of the first face of the cap layer and the flat upper face of the device layer is zero. This enables precise control of vertical distance between functional elements on the preferably flat device layer 40 and on the cap wafer 10, since the vertical distance is fully determined by recesses in the cap wafer 10 as shown in figures 4A and 4B.

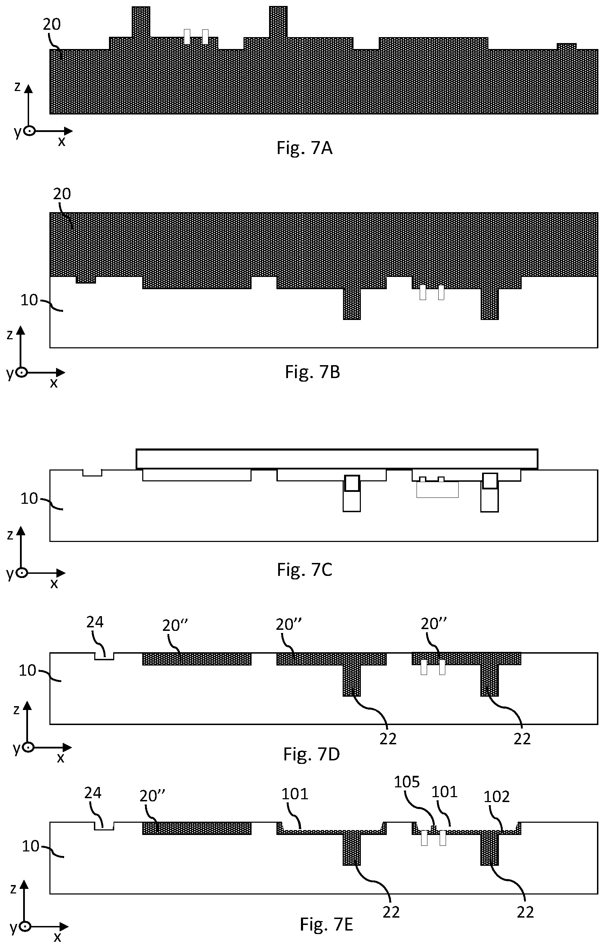

Figures 7A to 7D illustrate steps of a manufacturing process of a cap layer according to some embodiments.

Steps illustrated in figures 7A and 7B correspond to steps illustrated in connection with figures 2A and 2B. In this example, the recess 24 is generated using the mold 20. Alternatively, the recess 24 can be generated by dry or wet etching the cap wafer 10. Applicable wet etching methods are for example Potassium Hydroxide (KOH) etching and tetramethyl ammonium hydroxide (TMAH) etching.

In the step 7C, the entire mold 20 is removed. Removal of the mold 20 can be performed by etching, for example wet etching or vapor etching. Alternatively, removal of the mold 20 can be implemented in two steps, combining grinding and etching. Grinding is first used to reduce thickness of the mold before remaining portions of the mold 20 are removed by etching.

In the step 7D, recesses in the cap wafer 10 are filled by depositing polysilicon. In this context, polysilicon, poly-Si, known also as polycrystalline silicon or multicrystalline silicon refers to silicon consisting of small crystals, known as crystallites. Polysilicon is doped to make it electrically conducting. Poly-Si comprises mutually differently aligned crystals. Therefore, its elasticity constant is not dependent on geometry and/or direction. Electrical characteristics of poly-Si are relatively easy and economical to adjust in comparison to adjusting electrical characteristics of mono-Si.

Applied poly-Si covers recesses in the cap wafer 10, thus forming filled areas 20" and also silicon pillars 22 but is also applied at least on the entire the upper face of the cap wafer 10. To remove any excess deposited poly-Si from the upper face of the cap wafer 10, the upper face is subjected to chemical-mechanical polishing to even out the upper face such that applied poly-Si remains only in wanted recesses. In the embodiment shown in Figures 7A to 7D, the mold 20 also determines one or more recesses 24, from which poly-Si is removed or deposition of poly-Si is prevented for example by masking. Alternatively, cap wafer 10 may be etched to determine recesses 24.

Figure 5E illustrates result of the next step, in which at least some of the poly-Si fillings on the upper face of the cap wafer 10 are recessed to form gaps 101. This step corresponds to step shown in the Figure 2d with the difference that gaps 101 are formed in selected ones of the poly-Si filled portions 20" instead of remaining portions of the mono-Si mold. Like with mono-Si, gaps 101 are preferably created in poly-Si by dry etching, such as DRIE or plasma enhanced reactive ion etching (PERIE).

From this step onwards, the manufacturing process is similar to what is already described above, namely various metal processing steps may be performed to generate further conductive structures such as metal film patterns. Also bumps may be added. Finally, the cap is bonded on top of the device layer using a selected bonding method such as anodic bonding as illustrated with figures 2F and 3 or metal bonding as illustrated with figures 4A and 4B.

It is apparent to a person skilled in the art that as technology advanced, the basic idea of the invention can be implemented in various ways. The invention and its embodiments are therefore not restricted to the above examples, but they may vary within the scope of the claims.

## Claims

1. A MEMS device comprising:
- a cap layer (5), the cap layer comprising a cap wafer (10) made of electrically insulating material, such as glass, and
- a device layer (40) comprising at least one seismic element (401),
**characterized in that** the cap layer (5) comprises at least one silicon-filled portion (100, 20', 20") at a first face of the cap layer facing the device layer (40), and
at least one of said at least one silicon-filled portion (100, 20', 20") comprises a gap (101), wherein the gap (101) is a recessed area in the respective silicon-filled portion (100, 20', 20") that locally increases distance from the cap layer (5) to the at least one seismic element (401) comprised in the device layer (40).

2. The MEMS device according to claim 1, wherein the at least one silicon-filled portion (100, 20', 20") is filled with monocrystalline silicon or with polycrystalline silicon.

3. The MEMS device according to claim 1 or 2, wherein the cap layer (5) further comprises at least one silicon bump (105) extending from the gap (101) towards the device layer (40), wherein the silicon bump (105) is electrically insulated from other portions of the gap (101) by at least one exposed portion of the cap wafer (10).

4. The MEMS device according to any one of claims 1 to 3, further comprising at least one metal film pattern (112) disposed on a silicon surface of the gap (101).

5. The MEMS device according to claim 4, further comprising at least one bump (115) extending from the at least one metal film pattern (112) towards the device layer (40).

6. The MEMS device according to any one of claims 1 to 5, wherein at least one of the silicon-filled portions (100, 20', 20") forms a silicon pillar (22) extending between the first face of the cap layer (5) and a second face of the cap layer (5) facing away from the device layer (40).

7. The MEMS device according to any one of claims 1 to 6, wherein the cap layer (5) comprises at least one metallic press contact (106) configured to electrically couple the cap layer (5) to the superposed device layer (40).

8. The MEMS device according to any one of claims 1 to 7, wherein at least one exposed portion of glass at the first face of the cap layer (5) comprises at least one recess (24) configured to facilitate metal bonding of the first face of the cap layer (5) with the device layer (40).

9. A method of manufacturing a MEMS device, the method comprising:
a) providing a three-dimensionally patterned silicon mold (20);
b) depositing glass or applying heat-softened glass on the three-dimensionally patterned silicon mold to create a cap wafer (10) with a three-dimensionally patterned first face, and optionally grinding the cap wafer (10) to remove excess edge glass and/or to planarize a second face of the cap wafer (10);
c) removing at least part of the silicon mold (20) by grinding and/or chemical-mechanical polishing;
d) optionally removing remaining portions of the silicon mold (20) by etching;
e) if the remaining portions of the silicon mold (20) are removed by etching in step d), depositing a layer of polysilicon on the first face of the cap wafer (10), and thinning the deposited layer of polysilicon by grinding and/or chemical-mechanical polishing;
wherein, as a result of step c) or step e), a first face of a cap layer (5) comprises a flat surface comprising one or more silicon-filled portions (100, 20', 20") and one or more areas of exposed glass;
f) at least partially recessing at least one of the one or more silicon-filled portions (100, 20', 20") below the flat surface at the first face of the cap layer (5) by etching to generate at least one gap (101); and
h) bonding the cap wafer (10) at its first face to a device layer (40) such that the at least one gap (101) is superposed with one or more seismic elements (401) comprised in the device layer (40).

10. The method according to claim 9, further comprising:
- between steps f) and h), placing at least one metal film pattern (112) on the first face of the cap layer (5) at a bottom of at least one of the at least one gap (101).

11. The method according to claim 10, further comprising:
- generating at least one bump (115) on the metal film pattern (112).

12. The method according to any one of claims 9 to 11, wherein at least one of the at least one silicon-filled portion (100, 20', 20") forms a silicon pillar (22) extending from the first face of the cap layer (5) towards the second face of the cap layer (5), wherein the method comprises:
before step h) performing step
g) thinning the cap wafer (10) at the second face of the cap layer (5) to expose the at least one silicon pillar (22) on the second face of the cap layer (5), or
after step h) performing step
i) thinning the cap layer (5) at the second face to expose the at least one silicon pillar (22) at the second face of the cap layer (5),
for providing, by the at least one silicon pillar (22), an electrical contact between the first face of the cap layer (5) and the second face of the cap layer (5).

13. The method according to claim 12, further comprising providing at least one of the at least one silicon pillar (22) with a metallic press contact (106) at the first face of the cap layer (5).

14. The method according to any one of claims 9 to 13, wherein the three-dimensionally patterned silicon mold (20) determines at least one recess (24) at the first face of the cap wafer (10) that is not filled with poly-Si in the step e) or from which all deposited poly-Si is removed in the step f), or the method further comprises a step of etching at least one recess (24) in at least one area of exposed glass at the first face of the cap wafer (10), and wherein step h) comprises:
- providing the at least one recess (24) with a first metal pattern (50) at the bottom thereof, and
- providing at least one second metal pattern (51) on a face of the device layer (40), wherein the second metal pattern (51) is superposed with a respective first metal pattern (50) when the cap layer (5) and the device layer (40) are superposed, and
- metal bonding the first face of the cap layer (5) with the face of the device layer (40) by heating the first metal pattern (50) and the second metal pattern (51) to form a eutectic metal phase (45).

15. The method according to claim 14, wherein the first metal pattern (50) comprises any one of aluminum or germanium, and the second metal pattern (51) comprises the other one of aluminum and germanium.

## Patentansprüche

1. MEMS-Bauelement umfassend:
- eine Deckschicht (5), wobei die Deckschicht einen Deckwafer (10) umfasst, der aus einem elektrisch isolierenden Material, wie Glas, hergestellt ist, und
- eine Bauelementschicht (40), die mindestens ein seismisches Element (401) umfasst,
**gekennzeichnet dadurch, dass** die Deckschicht (5) mindestens einen Silizium-gefüllten Abschnitt (100, 20', 20") auf einer der Bauelementschicht (40) zugewandten ersten Fläche der Deckschicht umfasst, und
mindestens einer des mindestens einen Silizium-gefüllten Abschnitts (100, 20', 20") eine Lücke (101) umfasst, wobei die Lücke (101) ein ausgesparter Bereich im entsprechenden Silizium-gefüllten Abschnitt (100, 20', 20") ist, der den Abstand der Deckschicht (5) zu dem in der Bauelementschicht (40) enthaltenen mindestens einen seismischen Element (401) örtlich erhöht.

2. MEMS-Bauelement nach Anspruch 1, wobei der mindestens eine Silizium-gefüllte Abschnitt (100, 20', 20") mit monokristallinem Silizium oder mit polykristallinem Silizium gefüllt ist.

3. MEMS-Bauelement nach Anspruch 1 oder 2, wobei die Deckschicht (5) ferner mindestens einen Silizium-Höcker (105) umfasst, der sich von der Lücke (101) in Richtung der Bauelementschicht (40) erstreckt, wobei der Silizium-Höcker (105) durch mindestens einen freiliegenden Abschnitt des Deckwafers (10) zu anderen Abschnitten der Lücke (101) elektrisch isoliert ist.

4. MEMS-Bauelement nach einem der Ansprüche 1 bis 3, das ferner mindestens eine Metallfilmstruktur (112) umfasst, die auf einer Silizium-Oberfläche der Lücke (101) angeordnet ist.

5. MEMS-Bauelement nach Anspruch 4, das ferner mindestens einen Höcker (115) umfasst, der sich von der mindestens einen Metallfilmstruktur (112) in Richtung der Bauelementschicht (40) erstreckt.

6. MEMS-Bauelement nach einem der Ansprüche 1 bis 5, wobei mindestens einer der Silizium-gefüllten Abschnitte (100, 20', 20") eine Siliziumsäule (22) bildet, die sich zwischen der ersten Fläche der Deckschicht (5) und einer von der Bauelementschicht (40) abgewandten zweiten Fläche der Deckschicht (5) erstreckt.

7. MEMS-Bauelement nach einem der Ansprüche 1 bis 6, wobei die Deckschicht (5) mindestens einen metallischen Druckkontakt (106) umfasst, der dazu ausgelegt ist, die Deckschicht (5) mit der aufgelegten Bauelementschicht (40) elektrisch zu koppeln.

8. MEMS-Bauelement nach einem der Ansprüche 1 bis 7, wobei mindestens ein freiliegender Abschnitt aus Glas an der ersten Fläche der Deckschicht (5) mindestens eine Aussparung (24) umfasst, die dazu ausgelegt ist, die Metallverbindung der ersten Fläche der Deckschicht (5) mit der Bauelementschicht (40) zu vereinfachen.

9. Verfahren zur Herstellung eines MEMS-Bauelements, wobei das Verfahren umfasst:
a) Bereitstellen einer dreidimensional strukturierten Siliziumform (20);
b) Abscheiden von Glas oder Aufbringen von thermisch erweichtem Glas auf die dreidimensional strukturierte Siliziumform, um einen Deckwafer (10) mit einer dreidimensional strukturierten ersten Fläche herzustellen, und optional Schleifen des Deckwafers (10) zur Beseitigung von überschüssigem Kantenglas und/oder zur Planarisierung einer zweiten Fläche des Deckwafers (10);
c) Beseitigen mindestens eines Teils der Siliziumform (20) durch Schleifen und/oder chemisch-mechanisches Polieren;
d) optional Beseitigen von verbleibenden Abschnitten der Siliziumform (20) durch Ätzen;
e) falls die verbleibenden Abschnitte der Siliziumform (20) in Schritt d) weggeätzt werden, Abscheiden einer Schicht von Polysilizium auf die erste Fläche des Deckwafers (10), und Abdünnen der abgeschiedenen Schicht von Polysilizium durch Schleifen und/oder chemisch-mechanisches Polieren;
wobei, im Ergebnis von Schritt c) oder Schritt e), eine erste Fläche einer Deckschicht (5) eine plane Oberfläche aufweist, die einen oder mehrere Silizium-gefüllte Abschnitte (100, 20', 20") und einen oder mehrere Bereiche von freiliegendem Glas umfasst;
f) mindestens teilweises Aussparen von mindestens einem der einen oder mehreren Silizium-gefüllten Abschnitte (100, 20', 20") unterhalb der planen Oberfläche an der ersten Fläche der Deckschicht (5) durch Ätzen, um mindestens eine Lücke (101) zu erzeugen; und
h) Bonden des Deckwafers (10) an seiner ersten Fläche mit einer Bauelementschicht (40) dergestalt, dass die mindestens eine Lücke (101) mit einem oder mehreren in der Bauelementschicht (40) enthaltenen seismischen Elementen (401) überlagert wird.

10. Verfahren nach Anspruch 9, ferner umfassend:
- zwischen den Schritten f) und h), Platzieren mindestens einer Metallfilmstruktur (112) auf die erste Fläche der Deckschicht (5) am Boden mindestens einer der mindestens einen Lücke (101).

11. Verfahren nach Anspruch 10, ferner umfassend:
- Erzeugen mindestens eines Höckers (115) auf der Metallfilmstruktur (112).

12. Verfahren nach einem der Ansprüche 9 bis 11, wobei mindestens einer des mindestens einen Silizium-gefüllten Abschnitts (100, 20', 20") eine Siliziumsäule (22) bildet, die sich von der ersten Fläche der Deckschicht (5) in Richtung der zweiten Fläche der Deckschicht (5) erstreckt, wobei das Verfahren umfasst:
vor Schritt h) das Ausführen des Schritts
g) Abdünnen des Deckwafers (10) an der zweiten Fläche der Deckschicht (5), um die mindestens eine Siliziumsäule (22) auf der zweiten Fläche der Deckschicht (5) freizulegen, oder
nach Schritt h) das Ausführen des Schritts
i) Abdünnen der Deckschicht (5) an der zweiten Fläche, um die mindestens eine Siliziumsäule (22) an der zweiten Fläche der Deckschicht (5) freizulegen,
zum Bereitstellen eines elektrischen Kontakts zwischen der ersten Fläche der Deckschicht (5) und der zweiten Fläche der Deckschicht (5) über die mindestens eine Siliziumsäule (22).

13. Verfahren nach Anspruch 12, ferner umfassend: Versehen mindestens einer der mindestens einen Siliziumsäule (22) mit einem metallischen Druckkontakt (106) an der ersten Fläche der Deckschicht (5).

14. Verfahren nach einem der Ansprüche 9 bis 13, wobei die dreidimensional strukturierte Siliziumform (20) an der ersten Fläche des Deckwafers (10) mindestens eine Aussparung (24) bestimmt, die in Schritt e) nicht mit Poly-Si gefüllt wird oder aus der in Schritt f) das gesamte abgeschiedene Poly-Si entfernt wird, oder das Verfahren ferner einen Schritt umfasst: Ätzen mindestens einer Aussparung (24) in mindestens einem Bereich von freiliegendem Glas an der ersten Fläche des Deckwafers (10), und wobei Schritt h) umfasst:
- Versehen der mindestens einen Aussparung (24) mit einer ersten Metallstruktur (50) an ihrem Boden, und
- Bereitstellen mindestens einer zweiten Metallstruktur (51) auf einer Fläche der Bauelementschicht (40), wobei die zweite Metallstruktur (51) mit einer entsprechenden ersten Metallstruktur (50) überlagert wird, wenn die Deckschicht (5) und die Bauelementschicht (40) übereinandergelegt werden, und
- metallisches Bonden der ersten Fläche der Deckschicht (5) mit der Fläche der Bauelementschicht (40) durch Erhitzen der ersten Metallstruktur (50) und der zweiten Metallstruktur (51) zur Ausbildung einer eutektischen Metallphase (45).

15. Verfahren nach Anspruch 14, wobei die erste Metallstruktur (50) eines von Aluminium oder Germanium umfasst und die zweite Metallstruktur (51) das andere von Aluminium oder Germanium umfasst.

## Revendications

1. Dispositif MEMS comprenant :
- une couche de couverture (5), ladite couche de couverture comprenant une tranche de couverture (10) qui est faite d'un matériau électriquement isolant, tel que le verre, et
- une couche de dispositif (40) comprenant au moins un élément sismique (401),
**caractérisé en ce que** la couche de couverture (5) comprend au moins une partie remplie de silicium (100, 20', 20") sur une première face de la couche de couverture tournée vers la couche de dispositif (40), et
au moins l'une de ladite au moins une partie remplie de silicium (100, 20', 20") comprend un dégagement (101), ledit dégagement (101) étant une zone évidée dans la partie remplie de silicium respective (100, 20', 20") qui augmente localement la distance depuis la couche de couverture (5) jusqu'audit au moins un élément sismique (401) compris dans la couche de dispositif (40).

2. Dispositif MEMS selon la revendication 1, dans lequel ladite au moins une partie remplie de silicium (100, 20', 20") est remplie d'un silicium monocristallin ou d'un silicium polycristallin.

3. Dispositif MEMS selon la revendication 1 ou 2, dans lequel la couche de couverture (5) comprend également une bosse de silicium (105) s'étendant à partir du dégagement (101) vers la couche de dispositif (40), ladite bosse de silicium (105) étant isolée électriquement par au moins une partie exposée de la tranche de couverture (10) par rapport à d'autres parties du dégagement (101).

4. Dispositif MEMS selon l'une des revendications 1 à 3, comprenant également au moins un motif de film métallique (112) disposé sur une surface de silicium du dégagement (101).

5. Dispositif MEMS selon la revendication 4, comprenant également au moins une bosse (115) s'étendant à partir dudit au moins un motif de film métallique (112) vers la couche de dispositif (40).

6. Dispositif MEMS selon l'une des revendications 1 à 5, dans lequel au moins une des parties remplies de silicium (100, 20', 20") forme une colonne de silicium (22) s'étendant entre la première face de la couche de couverture (5) et une deuxième face de la couche de couverture (5) orientée à l'opposé de la couche de dispositif (40).

7. Dispositif MEMS selon l'une des revendications 1 à 6, dans lequel la couche de couverture (5) comprend au moins un contact de pression métallique (106) qui est configuré à coupler la couche de couverture (5) électriquement à la couche de dispositif (40) superposée.

8. Dispositif MEMS selon l'une des revendications 1 à 7, dans lequel au moins une partie en verre exposée sur la première face de la couche de couverture (5) comprend au moins un évidement (24) configuré pour faciliter la liaison métallique de la première face de la couche de couverture (5) à la couche de dispositif (40).

9. Procédé de fabrication d'un dispositif MEMS, ledit procédé comprenant les étapes consistant à :
a) fournir un moule de silicium structuré en trois dimensions (20);
b) déposer du verre ou appliquer du verre ramolli thermiquement sur le moule de silicium structuré en trois dimensions pour créer une tranche de couverture (10) avec une première face structurée en trois dimensions, et en option, meuler la tranche de couverture (10) pour éliminer le verre excédentaire du bord et/ou pour planariser une deuxième face de la tranche de couverture (10);
c) éliminer au moins une partie du moule de silicium (20) par meulage et/ou polissage chimico-mécanique;
d) en option, éliminer des parties résiduelles du moule de silicium (20) par gravure;
e) si les parties résiduelles du moule de silicium (20) sont éliminées par gravure dans l'étape d), déposer une couche de polysilicium sur la première face de la tranche de couverture (10), et amincir la couche déposée de polysilicium par meulage et/ou polissage chimico-mécanique;
dans lequel, à la suite de l'étape c) ou de l'étape e), une première face d'une couche de couverture (5) comprend une surface plane qui comprend une ou plusieurs parties remplies de silicium (100, 20', 20") et une ou plusieurs zones de verre exposées,
f) évider, au moins partiellement, au moins une desdites une ou plusieurs parties remplies de silicium (100, 20', 20") en dessous de la surface plane de la première face de la couche de couverture (5) par gravure afin de créer au moins un dégagement (101); et
h) lier la tranche de couverture (10) par sa première face à une couche de dispositif (40) de telle sorte que ledit au moins un dégagement (101) soit recouvert par un ou plusieurs éléments sismiques (401) compris dans la couche de dispositif (40).

10. Procédé selon la revendication 9, comprenant également l'étape consistant à :
- entre les étapes f) et h), placer au moins un motif de film métallique (112) sur la première face de la couche de couverture (5) au fond d'au moins l'un dudit au moins un dégagement (101).

11. Procédé selon la revendication 10, comprenant également l'étape consistant à :
- créer au moins une bosse (115) sur le motif de film métallique (112).

12. Procédé selon l'une des revendications 9 à 11, dans lequel au moins l'une de ladite au moins une partie remplie de silicium (100, 20', 20") forme une colonne de silicium (22) s'étendant de la première face de la couche de couverture (5) vers la deuxième face de la couche de couverture (5), le procédé comprenant les étapes consistant à :
avant l'étape h), effectuer l'étape consistant à
g) amincir la tranche de couverture (10) sur la deuxième face de la couche de couverture (5) pour exposer ladite au moins une colonne de silicium (22) sur la deuxième face de la couche de couverture (5), ou
après l'étape h), effectuer l'étape consistant à
i) amincir la couche de couverture (5) sur la deuxième face pour exposer ladite au moins une colonne de silicium (22) sur la deuxième face de la couche de couverture (5),
pour fournir, par ladite au moins une colonne de silicium (22), un contact électrique entre la première face de la couche de couverture (5) et la deuxième face de la couche de couverture (5).

13. Procédé selon la revendication 12, comprenant également l'étape consistant à pourvoir au moins l'une de ladite au moins une colonne de silicium (22) d'un contact de pression métallique (106) sur la première face de la couche de couverture (5).

14. Procédé selon l'une des revendications 9 à 13, dans lequel le moule de silicium structuré en trois dimensions (20) détermine au moins un évidement (25) sur la première face de la tranche de couverture (10) qui n'est pas rempli de poly-Si à l'étape e) ou qui est débarrassé de tout le poly-Si déposé à l'étape f), ou le procédé comprend également une étape consistant à graver au moins un évidement (24) dans au moins une zone de verre exposée sur la première face de la tranche de couverture (10), et dans lequel l'étape h) comprend les étapes consistant à :
- pourvoir ledit au moins un évidement (24) d'un premier motif métallique (50) au fond de celui-ci, et
- prévoir au moins un deuxième motif métallique (51) sur une face de la couche de dispositif (40), ledit deuxième motif métallique (51) étant recouvert par un premier motif métallique respectif (50) lorsque la couche de couverture (5) et la couche de dispositif (40) sont superposées l'une à l'autre, et
- réaliser une liaison métallique entre la première face de la couche de couverture (5) et la face de la couche de dispositif (40) par chauffage du premier motif métallique (50) et du deuxième motif métallique (51) pour former une phase métallique eutectique (45).

15. Procédé selon la revendication 14, dans lequel le premier motif métallique (50) comprend l'un parmi l'aluminium et le germanium et le deuxième motif métallique (51) comprend l'autre parmi l'aluminium et le germanium.
